# EUROPÄISCHE PATENTSCHRIFT

(11) **EP 2 786 162 B1**
(45) Veröffentlichungstag und Bekanntmachung des Hinweises auf die Patenterteilung: **06.01.2021**
(21) Anmeldenummer: 12805961.5
(22) Anmeldetag: 28.11.2012
(51) Int. Cl.: G01R 31/52, G01D 3/08

(54) **VERFAHREN ZUM FESTSTELLEN EINES FEHLERS IN VERBINDUNGLEITUNGEN ZWISCHEN EINER ZENTRALEINHEIT UND EINER MEHRZAHL VON VOREINANDER UNABHÄNGIGEN ELEKTRONISCHEN BAUEINHEITEN**
METHOD OF DETECTING A FAULT IN CONNECTING LINES BETWEEN A CENTRAL UNIT AND A PLURALITY OF ELECTRONIC COMPONENTS WHICH ARE INDEPENDENT OF ONE ANOTHER
PROCÉDÉ DE DÉTECTION D'UNE ERREUR DANS DES LIGNES DE CONNEXION ENTRE UNE UNITÉ CENTRALE ET UNE MULTIPLICITÉ D'UNITÉS ÉLECTRONIQUES INDÉPENDANTES L'UNE DE L'AUTRE

(30) Priorität: 30.11.2011 DE 102011087451
(43) Veröffentlichungstag der Anmeldung: 08.10.2014
(73) Patentinhaber: Robert Bosch GmbH, 70442 Stuttgart (DE)
(72) Erfinder: WEISS, Timo, 71701 Schwieberdingen (DE); WIEDMAIER, Jochen, 70825 Korntal-Muenchingen (DE); SIEMSS, Matthias, 72810 Gomaringen (DE); WEISS, Guenter, 74399 Walheim (DE)
(86) Internationale Anmeldenummer: PCT/EP2012/073819
(87) Internationale Veröffentlichungsnummer: WO 2013/079520

(56) Entgegenhaltungen:
- EP-A1- 0 418 665
- DE-A1-102007 059 365

## Beschreibung

### Stand der Technik

Die vorliegende Erfindung bezieht sich auf ein Verfahren zum Feststellen eines Fehlers in Verbindungleitungen zwischen einer Zentraleinheit und einer Mehrzahl von voneinander unabhängigen elektronischen Baueinheiten, auf eine entsprechende Vorrichtung sowie auf ein entsprechendes Computerprogrammprodukt.

Ein Cross-Coupling-Test (deutsch: Test auf Kreuzverkopplung) zwischen PSI5-Schnittstellen eines oder mehrerer ASICs auf einer Leiterkarte wurde bisher per Software-Steuerung durchgeführt. Dies ist jedoch sehr zeitaufwändig, da die Steuerung des Tests per Software eine erhebliche Anzahl von auszulesenden und auszuführenden Befehlen erfordert. Insbesondere in der Kraftfahrzeugtechnik, in der alle sicherheitsrelevanten Systeme vor einem Beginn einer Fahrt gründlich geprüft werden müssen, kann dies in zukünftigen Fahrzeugen mit einer hohen Anzahl von miteinander verbundenen Sensoren als Baueinheiten einen erheblichen Zeitaufwand bedeuten, bevor das Fahrzeug in Betrieb genommen werden kann. Dies ist für einen Nutzer des Fahrzeugs wenig komfortabel.

Aus der EP 0 418 665 A1 ist bekannt eine Vorrichtung, die einen Steuerschaltkreis mit einem integrierten Leistungstransistor aufweist, der die elektrische Versorgungsleistung eines Verbrauchers, eines Detektors und eines Logikschaltkreises, der mittels zweier Leitungen mit einem Computer verbunden ist, steuert. Der Computer steuert dabei sukzessive ausgewählte Logik-Subschaltkreise zur Detektion und Identifikation von funktionalen Fehlern in dem Versorgungsschaltkreis der Verbraucher, wobei die Auswahl durch spezifische Kombinationen von Logik-Signalen, die auf den Verbindungsleitungen angewendet werden, erfolgt. In Erwiderung induzieren die Schaltkreise auf den Verbindungsleitungen logische Level, die die Präsenz bzw. die Abwesenheit von Fehlern repräsentieren. Die entsprechenden Logik-Level werden während den Zeiträumen auf der Leitung eingespielt, zu der der Computer die Leitungen ausliest.

### Offenbarung der Erfindung

Vor diesem Hintergrund wird mit der vorliegenden Erfindung ein Verfahren vorgestellt. Vorteilhafte Ausgestaltungen ergeben sich aus den jeweiligen Unteransprüchen und der nachfolgenden Beschreibung.

Die vorliegende Erfindung schafft ein Verfahren zum Feststellen zumindest eines Fehlers in Verbindungsleitungen zwischen einer Mehrzahl von elektronischen Anschlusseinheiten und einer Mehrzahl von voneinander unabhängigen peripheren Einheiten, wobei die Anschlusseinheit durch einen flüchtig in eine Steuereinheit einprogrammierten Algorithmus gesteuert werden und wobei die Verbindungleitungen zwischen den peripheren Einheiten und der Anschlusseinheiten je mittels zumindest einer Zweidrahtleitung ausgeführt sind, wobei das Verfahren die folgenden Schritte aufweist:
- Ausgeben eines Startsignals von der Steuereinheit an eine erste der Anschlusseinheiten, um das Feststellen des Fehlers zu starten;
- Anlegen eines Testsignals an eine Schnittstelle einer ersten der Anschlusseinheiten, wobei das Anlegen des Testsignals durch einen nicht-flüchtig in der ersten Anschlusseinheit einprogrammierten ersten Algorithmus überwacht und/oder gesteuert wird;
- Erfassen eines Überkoppelns des Testsignals an eine Schnittstelle einer zweiten Anschlusseinheit und Ablegen eines das Überkoppeln repräsentierenden Fehlerwertes in einem ersten Register, wobei das Erfassen und Ablegen des Fehlerwertes durch einen nicht-flüchtig in der zweiten Anschlusseinheit einprogrammierten zweiten Algorithmus gesteuert wird; und
- Auslesen des zumindest einen Fehlerwertes durch die Steuereinheit zumindest aus dem ersten Register, um den Fehler in den Verbindungsleitungen zwischen der ersten Anschlusseinheit und der Mehrzahl von peripheren Einheiten festzustellen.

Ferner wird eine Vorrichtung geschaffen, die ausgebildet ist, um die Schritte des erfindungsgemäßen Verfahrens oder einer Variante davon in entsprechenden Einrichtungen durchzuführen bzw. umzusetzen. Auch durch diese Ausführungsvariante in Form einer Vorrichtung kann die der Erfindung zugrunde liegende Aufgabe schnell und effizient gelöst werden.

Unter einer Vorrichtung kann vorliegend ein elektrisches Gerät verstanden werden, das Sensorsignale verarbeitet und in Abhängigkeit davon Steuersignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind. Unter einem Überkoppeln ist einer Übertragung von elektrischen Signalen zu verstehen, die entweder durch eine elektrisch leitfähige Verbindung zwischen zwei elektrischen Leitern und/oder durch eine drahtlose Übertragung von Signalen zwischen zwei sich sehr nahe kommenden elektrischen Leitern zu verstehen.

Unter einer peripheren Einheit kann ein elektronisches Bauelement verstanden werden, welches in einem separaten eigenen Gehäuse angeordnet und über eine Verbindungsleitung mit weiteren Komponenten elektrisch verbunden oder zumindest verbindbar ist. Beispielsweise kann ein Halbleiter-Bauelement oder ein Sensor als periphere Einheit im Sinne dieser Beschreibung verstanden werden. Unter einer Anschlusseinheit kann eine elektronische Einheit verstanden werden, die eine um Testfunktionen erweiterte Schnittstelle zur Übertragung von Signalen zwischen einer Zentraleinheit und peripheren Einheiten ausgebildet ist. Eine solche Anschlusseinheit kann beispielsweise in der Form eines ASICs implementiert sein, in dem eine feste Verdrahtung von Steuerbefehlen oder - algorithmen implementiert ist. Unter einer Schnittstelle kann eine Vorrichtung zu Übertragung von Signalen wie beispielsweise ein Kabel oder ein Anschlussstecker verstanden werden. Unter einem Testsignal kann ein Signal mit einer vordefinierten Spannung, insbesondere einer statischen Spannung über einen bestimmten vordefinierten Zeitraum verstanden werden. Unter einem Überkoppeln des Testsignals kann eine Wirkung des Testsignals auf eine andere Schnittstelle verstanden werden, die beispielsweise durch eine fehlerhafte Isolation zwischen den beiden Schnittstellen verursacht ist. Eine solche fehlerhafte Isolation kann beispielsweise bei der Herstellung der Schnittstellen durch das versehentliche Aufbringen einer Lötfahne oder eine Beschädigung eines Isolationsmantels eines Kabels der Schnittstelle verursacht werden. Unter einem Fehlerwert kann allgemein eine Information verstanden werden, dass ein Fehler vorliegt. Unter einem Register kann ein Speicher verstanden werden, der die Information über einen aufgetretenen Fehler aufnehmen kann. Unter einem Algorithmus kann eine Abarbeitungsvorschrift zur Abarbeitung von Befehlen verstanden werden, wobei die Abarbeitungsvorschrift fest, d.h. statisch in einer Hardware einer Baueinheit implementiert ist. Insbesondere ist der Algorithmus nicht-flüchtig implementiert, das heißt nicht als Software in eine entsprechende Rechnereinheit der Baueinheit ladbar, so dass er nach einem Stromlos- oder Spannungslos-Schalten der Baueinheit wieder aus der Rechnereinheit der Baueinheit gelöscht wird.

Die vorliegende Erfindung basiert auf der Erkenntnis, dass ein relativ hoher Zeitbedarf und eine Komplexität eines per Software gesteuerten Cross-Coupling-Tests durch einen hardwarebasierten Test erheblich reduziert werden können. Insbesondere können die Anschlusseinheiten, die beispielsweise zur Kontaktierung von als peripheren Sensoren oder ASICs in diesen peripheren Sensoren gebildet sind, eine Hardware-Schaltung aufweisen, in denen der Algorithmus zur Steuerung des Kreuzverkopplungstests implementiert ist. Auf diese Weise kann beispielsweise die Betriebsbereitschaft eines mit PSI5-Schnittstellen ausgerüsteten Steuergerätes nach dem Start eines Fahrzeuges schneller erreicht werden.

Günstig ist es, wenn gemäß seiner Ausführungsform der vorliegenden Erfindung im Schritt des Erfassens ferner ein Erfassen eines Überkoppelns des Testsignals auf eine zweite Schnittstelle der ersten Anschlusseinheit und ein Ablegen eines das Überkoppeln repräsentierenden zweiten Fehlerwertes in ein zweites Register erfolgen, wobei das Erfassen eines Überkoppelns des Testsignals auf eine zweite Schnittstelle der ersten Anschlusseinheit und das Ablegen des zweiten Fehlerwertes durch den ersten Algorithmus überwacht und/oder gesteuert werden. Eine derartige Ausführungsform der vorliegenden Erfindung bietet den Vorteil, dass nicht nur eine Wirkung des Testsignals an einer anderen Anschlusseinheit als der das Testsignal ausgebenden Anschlusseinheit gemessen werden kann, wodurch sich der hier vorgestellten Ansatz nicht nur zur Überprüfung von Verbindungen zwischen einzelnen Anschlusseinheiten, sondern auch zur Überprüfung der Verbindung einzelner Schnittstelle ein der eigenen Anschlusseinheit eignet.

Gemäß einer weiteren Ausführungsform der vorliegenden Erfindung kann ferner ein Schritt des Anlegens eines weiteren Testsignals an der Schnittstelle der zweiten Anschlusseinheit vorgesehen sein, wobei das Anlegens des weiteren Testsignals durch den zweiten Algorithmus überwacht und/oder gesteuert wird und wobei ferner Schritte des Erfassens eines Überkoppelns des weiteren Testsignals an die erste Schnittstelle in der ersten Anschlusseinheit und des Ablegens eines das Überkoppeln des weiteren Testsignals repräsentierenden dritten Fehlerwertes in einem dritten Register vorgesehen ist, wobei die Schritte des Erfassens des Überkoppelns des weiteren Testsignals und des Ablegens des dritten Fehlerwertes durch den ersten Algorithmus überwacht werden. Eine derartige Ausführungsform der vorliegenden Erfindung bietet die Möglichkeit, dass nicht nur eine der Anschlusseinheiten als "Master" für die Überprüfung der Fehlerfreiheit der Verbindungsleitungen zwischen den Baueinheiten verwendbar ist. Auf diese Weise wird eine deutlich größere Anzahl von möglichen Fehlern prüfbar.

Auch kann gemäß einer zusätzlichen Ausführungsform der vorliegenden Erfindung im Schritt des Erfassens eines Überkoppelns des weiteren Testsignals ferner ein Erfassen eines Überkoppelns des weiteren Testsignals auf zumindest eine zweite Schnittstelle der zweiten Anschlusseinheit und ein Ablegen eines das Überkoppeln repräsentierenden vierten Fehlerwertes in einem vierten Register erfolgen, wobei das Erfassen des Überkoppelns des weiteren Testsignals und das Ablegen des vierten Fehlerwertes durch den zweiten Algorithmus überwacht und/oder gesteuert werden. Eine derartige Ausführungsform der vorliegenden Erfindung bietet ebenfalls den Vorteil, dass, auch wenn eine zweite Anschlusseinheit als Master zum Ausgeben des weiteren Testsignals verwendet wird, ein Fehler zwischen einer Verbindung zwischen zwei Schnittstellen der zweiten Anschlusseinheit erkannt werden kann.

Um eine Entlastung der Software-gesteuerten Zentraleinheit zu erreichen, sollte die Durchführung der Fehlererkennung von Fehlern in den Verbindungsleitungen zwischen den Baueinheiten durch einen oder mehrere in Hardware implementierte Algorithmen erfolgen. Besonders günstig ist es daher, wenn einen die Umschaltung der einzelnen der Anschlusseinheiten als "Master" zur Ausgabe eines entsprechenden Testsignals ebenfalls durch die entsprechenden Algorithmen in den jeweiligen Anschlusseinheiten erfolgt. Gemäß einer weiteren Ausführungsform der vorliegenden Erfindung kann daher vor dem Schritt des Anlegens des weiteren Testsignals ein Steuersignal vom ersten Algorithmus an den zweiten Algorithmus ausgegeben werden, um das Anlegen des weiteren Testsignals durch den zweiten Algorithmus zu starten.

Um eine möglichst schnelle und effiziente Überprüfung der Verbindungen zwischen der Steuereinheit der Zentraleinheit und der Mehrzahl von Anschlusseinheiten zu ermöglichen, sollte nach einem Anlegen eines Testsignals an eine Schnittstelle der ersten Anschlusseinheit nicht nur die Wirkung dieses Testsignals auf eine Schnittstelle einer zweiten Anschlusseinheit ausgewertet werden, sondern auch noch die Wirkung des Testsignals auf eine oder mehrere weitere Schnittstellen ausgewertet werden. Gemäß einer günstigen Ausführungsform der vorliegenden Erfindung kann daher im Schritt des Erfassens ferner ein Erfassen eines Überkoppelns des Testsignals auf eine Schnittstelle zumindest einer dritten Anschlusseinheit und ein Ablegen eines das Überkoppeln des Testsignals auf die Schnittstelle der dritten Anschlusseinheit repräsentierenden fünften Fehlerwertes in einem fünften Register erfolgen, wobei das Erfassen des Überkoppelns des Testsignals auf die Schnittstelle der dritten Anschlusseinheit und das Ablegen des fünften Fehlerwertes durch einen durch einen nicht-flüchtig in der dritten Anschlusseinheit einprogrammierten dritten Algorithmus überwacht und/oder gesteuert werden.

Um sicherzustellen, dass ein Überkoppeln des Testsignals auf eine andere Schnittstelle korrekt erfasst wird, sollte ein Einschwingen des Testsignals auf der Schnittstelle der ersten Anschlusseinheit berücksichtigt werden. Gemäß einer Ausführungsform der vorliegenden Erfindung kann daher zwischen dem Schritt des Anlegens und dem Schritt des Erfassens eine vordefinierte Zeitdauer abgewartet werden.

Um ein besonders schnelles Abspeichern der Fehlerwerte in den betreffenden Baueinheiten oder ein besonders schnelles Auslesen der ermittelten Fehlerwerte durch die Steuereinheit der Zentraleinheit zu ermöglichen, kann gemäß einer besonderen Ausführungsform der vorliegenden Erfindung im Schritt des Erfassens ein Ablegen des Fehlerwertes in dem ersten Register erfolgen, wobei das erste Register ein Teil der zweiten Anschlusseinheit ist oder wobei das erste Register ein Teil der Steuereinheit der Zentraleinheit ist.

Besonders vorteilhaft kann der vorstehend vorgestellte Ansatz in einem Szenario eingesetzt werden, in dem das Verfahren unter Verwendung von PSI5-Schnittstellen zumindest als Schnittstelle in der ersten Anschlusseinheit und als Schnittstelle in der zweiten Anschlusseinheit ausgeführt wird. Insbesondere kann der vorstehend beschriebene Ansatz im Bereich der Kraftfahrzeugtechnik oder der Kraftfahrzeugelektronik eingesetzt werden.

Die Erfindung wird nachstehend anhand der beigefügten Zeichnungen beispielhaft näher erläutert. Es zeigen:
- Fig. 1: ein Blockschaltbild eines Fahrzeugs, in dem ein Ausführungsbeispiel der vorliegenden Erfindung eingesetzt wird;
- Fig. 2: ein Ablaufdiagramm eines Ausführungsbeispiels der vorliegenden Erfindung als Verfahren;
- Fig. 3: weiteres detaillierteres Ablaufdiagramm eines Verfahrens zur Anwendung in einem Ausführungsbeispiels der vorliegenden Erfindung; und
- Fig. 4: ein weiteres detaillierteres Ablaufdiagramm eines Verfahrens zur Anwendung in einem Ausführungsbeispiel der vorliegenden Erfindung.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

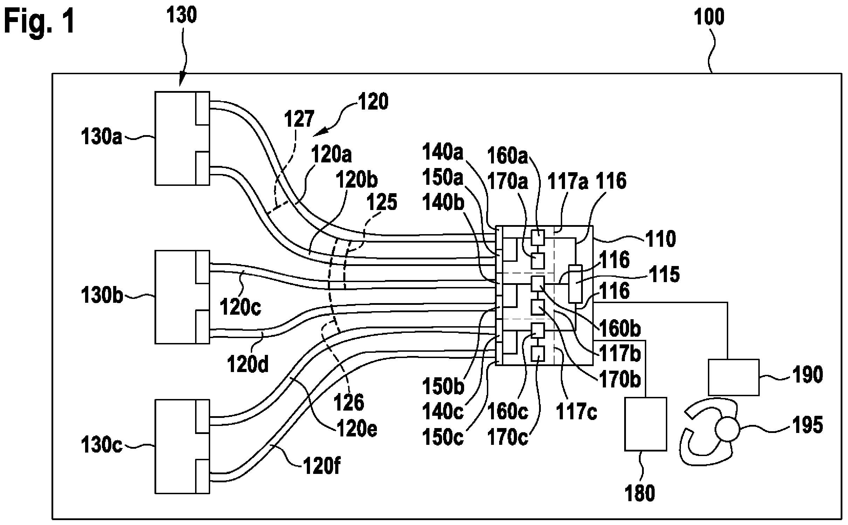

Fig. 1 zeigt ein Blockschaltbild eines Fahrzeugs 100, in dem ein Ausführungsbeispiel der vorliegenden Erfindung verwendet wird. Hierbei ist eine Softwaregesteuerte Zentraleinheit 110 vorgesehen. Die Zentraleinheit 110 umfasst eine Steuereinheit 115, die beispielsweise als Mikrocontroller oder digitaler Signalprozessor ausgebildet ist und die beispielsweise über einen SPI-Bus 116 mit Anschlusseinheiten 117 verbunden sind, die als Hardware-Schnittstelle zur Kontaktierung von nachfolgend noch näher beschriebenen externen Einheiten vorgesehen sind. Die Anschlusseinheiten 117 sind über Verbindungsleitungen 120, die jeweils als Zweidraht-Signalleitungen (beispielsweise in der Form einer PSI5-Verbindungsleitung oder Schnittstelle) ausgestaltet sind, mit Schnittstellen einer Mehrzahl von peripheren Einheiten 130 verbunden. In der Fig. 1 sind dabei ohne Beschränkung der Allgemeinheit nur drei periphere Einheiten 130, nämlich eine erste Einheit 130a, eine zweite Einheit 130b und eine dritte Einheit 130c. Es können jedoch noch weitere (in der Fig. 1 nicht explizit dargestellte) Einheit 130 vorgesehen sein, die analog mittels entsprechender Verbindungsleitungen 120 mit jeweils zugeordneten Anschlusseinheiten 117 angeschlossen sind. Jede der Anschlusseinheiten 117 umfasst beispielsweise eine erste Schnittstelle 140 eine zweite Schnittstelle 150, einen in einer Hardware der betreffenden Anschlusseinheit 117 nicht-flüchtig eingespeicherten Algorithmus 160 sowie ein Register 170, in welchem ein oder mehrere Fehlerwerte eingespeichert werden können.

Die peripheren Einheiten 130 können Sensoren (beispielsweise Beschleunigungssensoren, Drucksensoren oder Körperschallsensoren oder ähnliche) sein, die ein entsprechendes Sensorsignal an eine der Schnittstellen 140 oder 150 der Anschlusseinheiten 117 senden, sodass die betreffende Anschlusseinheit 117 das von dem jeweils betreffenden Sensor gesendete Signal auswerten kann und beispielsweise ein Personensicherheitsmittel wie einen Airbag 180 oder einen Gurtstraffer 190 zur Optimierung einer Sicherheit eines Insassen 195 des Fahrzeugs 100 aktivieren kann.

Um nun die einzelnen Schnittstellen 140 bzw. 150 der jeweiligen Anschlusseinheiten 117 der Zentraleinheit 110 mit der Steuereinheit 115 der Zentraleinheit zu verbinden, ist beispielsweise die erste Schnittstelle 140a der ersten Anschlusseinheit 117a über eine erste Verbindungsleitung 120a mit der ersten peripheren Einheit 130a verbunden, die zweite Schnittstelle 150a der ersten Anschlusseinheit 117a über eine zweite Verbindungsleitung 120b mit der ersten peripheren Einheit 130a verbunden, die erste Schnittstelle 140b der zweiten Anschlusseinheit 117b über eine dritte Verbindungsleitung 120c mit einer zweiten peripheren Einheit 130b, die zweite Schnittstelle 150b der zweiten Anschlusseinheit 117b über eine vierte Verbindungsleitung 120d ebenfalls mit der zweiten peripheren Einheit 130b verbunden, die erste Schnittstelle 140c der dritten Anschlusseinheit 117c über eine fünfte Verbindungsleitung 120e mit einer dritten peripheren Einheit 130c verbunden und eine zweite Schnittstelle 150c der dritten Anschlusseinheit 117c über eine sechste Verbindungsleitung 120f mit der dritten peripheren Einheit 130c Zentraleinheit 110 verbunden. Es ist auch denkbar, dass jede der peripheren Einheiten 130 nur über eine Verbindungsleitung 120 mit einer entsprechenden Anschlusseinheit 117 der Zentraleinheit 110 verbunden ist.

Um nun die korrekte Funktion und Fehlerfreiheit der einzelnen Verbindungsleitungen 120 zu prüfen, wurde bisher ein Prüfalgorithmus durch die Softwaregesteuerte Steuereinheit 115 in der Zentraleinheit 110 ausgeführt, was jedoch durch das Einlesen, Interpretieren und Ausführen von einzelnen Kommandos des Prüfalgorithmus in der Steuereinheit 115 aufwändig und somit langsam war. Gemäß dem hier vorgestellten Ansatz wird nun von der Steuereinheit 115 ein Signal, beispielsweise an die erste Anschlusseinheit 117a geschickt, um das Durchführen der Fehlerprüfung durch einen in der Hardware der ersten Anschlusseinheit 117a implementierten Algorithmus 160a bzw. eine entsprechend ausgestattete Steuereinheit, die diesen Algorithmus 160a ausführen kann, zu starten.

Dazu wird beispielsweise ein Testsignal an der ersten Schnittstelle 140a der ersten Anschlusseinheit 117a angelegt. Dieses Testsignal kann beispielsweise darin bestehen, dass ein vordefinierter Spannungspegel zwischen den beiden Drähten der ersten Verbindungsleitungen 120a aufgeprägt wird. Besteht nun ein Fehler in den Verbindungen 120, beispielsweise durch eine schadhafte Isolation oder eine Lötfahne 125 zwischen einem der Drähte der ersten Verbindungsleitung 120a und einem Draht der dritten Verbindungsleitung 120c, kann dieser Fehler an der ersten Schnittstelle 140b der zweiten Anschlusseinheit 117b erkannt werden. In diesem Fall wird beispielsweise ein Spannungspegel auf der dritten Verbindungsleitung 120c größer sein, als dies ohne den Fehler in Form der Lötfahne 125 der Fall wäre. An der ersten Schnittstelle 140b der zweiten Anschlusseinheit 117b kann somit das Überkoppeln des Testsignals von der ersten Verbindungsleitung 120a auf die dritte Verbindungsleitung 120c erfasst werden. Die zweite Anschlusseinheit 117b ist in diesem Fall in einem Zustand, in dem selbst kein Testsignal auf eine der Verbindungsleitungen 120c und 120d über eine der Schnittstellen 140b oder 150b ausgegeben wird, sondern es wird vielmehr ein Überkoppeln des Testsignals auf die dritte und/oder vierte Verbindungsleitung 120 bzw. 120d an den jeweiligen Schnittstellen an 140b und 150b überwacht. Wird nun erkannt, dass beispielsweise durch das Vorliegen des Fehlers 125 das Testsignal auf die dritte Verbindungsleitung 120c überkoppelt, kann dies durch den in die Hardware der zweiten Anschlusseinheit 117b fest einprogrammierten Algorithmus 160b erfasst und in einen entsprechenden Speicher bzw. ein entsprechendes Register 170b der zweiten Anschlusseinheit 117b gespeichert werden.

Auf die vorstehend beschriebene Weise kann auch ein Fehler zwischen der ersten Verbindungsleitung 120a und der fünften Verbindungsleitung 120e an der ersten Schnittstelle 140c der dritten Anschlusseinheit 117c erkannt werden, wobei dieser Fehler beispielsweise durch eine zweite Lötfahne 126 verursacht ist. In diesem Fall kann durch die Verwendung des Algorithmus 160c, der in die Hardware der dritten Anschlusseinheit 117c nicht-flüchtig einprogrammiert ist, einen diesen Fehler repräsentierenden Fehlerwert an der ersten Schnittstelle 140c der dritten Anschlusseinheit 117c erfassen und diesen Fehlerwert in einem Register oder einen Speicher 170c der dritten Anschlusseinheit 1117c einspeichern.

Um auch einen Fehler (beispielsweise durch einen Kurzschluss 127) zwischen der ersten und zweiten Verbindungsleitung 120a und 120b festzustellen, die in Schnittstellen einer einzigen peripheren Einheit beispielsweise der ersten peripheren Einheit 130a kann auch der Algorithmus 160a oder eine Steuereinheit, die den Algorithmus 160a ausführt) einen diesen Fehler 127 repräsentierenden Fehlerwert an der zweiten Schnittstelle 150a der ersten Anschlusseinheit 117a aufzeichnen und im dem Speicher oder dem Register 170a einspeichern.

Um nun möglichst alle auftretenden Fehler in den Verbindungsleitungen erfassen zu können, kann durch den Algorithmus 160a der ersten Anschlusseinheit 117a ein Steuersignal (beispielsweise über den SPI-Bus 116 und die Steuereinheit 115 der Zentraleinheit 110) an den Algorithmus 160b (oder eine diesen Algorithmus ausführende Steuereinheit) der zweiten Anschlusseinheit 117b senden, woraufhin der Algorithmus 160b in der zweiten Anschlusseinheit 117b (bzw. die Steuereinheit, die diesen Algorithmus 160b in der zweiten Anschlusseinheit 117b ausführt) beispielsweise ein (weiteres) Testsignal über die erste Schnittstelle 140b der zweiten Anschlusseinheit 117b auf die dritte Verbindungsleitung 120c ausgibt. Dieses weitere Testsignal kann beispielsweise dem zuvor über die erste Schnittstelle 140a der ersten Anschlusseinheit 117a ausgegebenen Testsignal in Form und Amplitude entsprechen. Auf diese Weise kann beispielsweise der Fehler 125, der durch die Lötfahne zwischen der ersten und dritten Verbindungsleitung 120a und 120c besteht, auch in der ersten Schnittstelle 140a der ersten Anschlusseinheit 117a erkannt und im Speicher 170a durch einen entsprechenden, diesen Fehler 125 repräsentierenden Fehlerwert abgelegt werden.

Durch eine Wiederholung dieser vorstehend beschriebenen Vorgehensweise kann nun beispielsweise jede der in Fig. 1 dargestellten Schnittstellen 140 bzw. 150 als Master-Schnittstelle dienen, über welche ein entsprechendes Testsignal auf die zugehörige Verbindungsleitung 120 ausgegeben wird, wobei in den anderen Schnittstellen, die entweder zur gleichen Anschlusseinheit oder zu anderen Anschlusseinheit gehören, eine Überprüfung der jeweiligen Schnittstellen auf ein Überkoppeln des an der Master-Schnittstelle angelegten Testsignals möglich wird. Dabei kann diese Überprüfung ohne die Ausführungen eines entsprechenden Software-Codes in der Steuereinheit 115 der Zentraleinheit 110 erfolgen, wodurch die Ausführung der Überprüfung der Fehlerfreiheit in den Verbindungsleitungen 120 gegenüber einer Anwendung eines Software-gesteuerten Algorithmus deutlich schneller ist.

Abschließend können die in den Registern 170 der einzelnen Anschlusseinheiten 117 eingespeicherten Fehlerwerte beispielsweise durch die Steuereinheit 115 der Zentraleinheit 110 ausgelesen werden, sodass der Fehlerstatus der jeweiligen Verbindungsleitungen 120 erfasst wird. Dieses Auslesen kann beispielsweise wieder unter Verwendung eines Software-basierten Algorithmus in der Zentraleinheit 110 erfolgen, da dieses Auslesen keine so große Anzahl von abzuarbeitenden Kommandos erfordert und daher hinreichend schnell ausgeführt werden kann. Ferner ist nur ein Lese-Kommando erforderlich, wenn ein Register die Fehlereinträge aller Schnittstellen enthält.

Dagegen würde ein per Software gesteuerter Cross-Coupling-Test (wie er im Stand der Technik erfolgt) erfolgt eine Vielzahl von Steuerkommandos an die zu testenden (PSI5-) Schnittstellen erfordern. Jede einzelne PSI5-Schnittstelle muss durch Software-Kommandos ein- und ausgeschaltet werden und der Status aller Schnittstellen ist nach jedem Einschaltkommando zu erfassen.

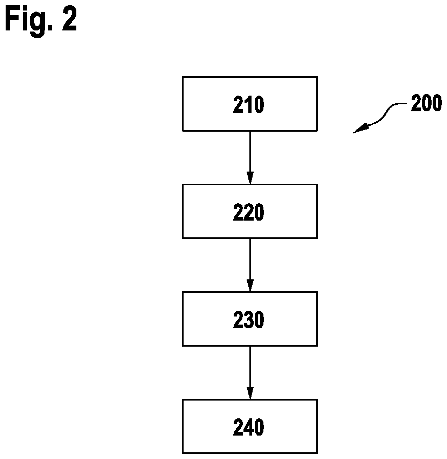

Fig. 2 zeigt ein Ablaufdiagramm eines Ausführungsbeispiels der vorliegenden Erfindung als Verfahren 200 zum Feststellen zumindest eines Fehlers in Verbindungsleitungen zwischen einer durch einen flüchtig in eine Zentraleinheit einprogrammierten Algorithmus gesteuerten Zentraleinheit und einer Mehrzahl von voreinander unabhängigen elektronischen Baueinheiten. Die die Verbindungsleitungen zwischen der Zentraleinheit und der Mehrzahl von Baueinheiten sind je mittels Zweidrahtleitung ausgeführt. Das Verfahren 200 umfasst einen Schritt des Ausgebens 210 eines Startsignals von der Zentraleinheit an eine erste der Baueinheiten, um das Feststellen des Fehlers zu starten. Weiterhin umfasst das Verfahren 200 einen Schritt des Anlegens 220 eines Testsignals an eine Schnittstelle einer ersten der Baueinheiten, wobei das Anlegen des Testsignals durch einen nicht-flüchtig in der ersten Baueinheit einprogrammierten ersten Algorithmus überwacht wird. Hierdurch wird ein Kurzschluss-nach-Masse-Monitor realisiert. Ferner umfasst das Verfahren 200 einen Schritt des Erfassens 230 eines Überkoppelns des Testsignals an eine Schnittstelle einer zweiten Baueinheit und Ablegen eines das Überkoppeln repräsentierenden Fehlerwertes in einem ersten Register, wobei das Erfassen und Ablegen des Fehlerwertes durch einen nicht-flüchtig in der zweiten Baueinheit einprogrammierten zweiten Algorithmus überwacht wird. Schließlich umfasst das Verfahren einen Schritt des Auslesens 240 des zumindest einen Fehlerwertes durch die Zentraleinheit zumindest aus dem ersten Register, um den Fehler in den Verbindungsleitungen zwischen der Zentraleinheit und der Mehrzahl von Baueinheiten festzustellen.

Ein hardwarebasierter Cross-Coupling-Test, wie er vorstehend beschrieben wurde, führt zu einer Reduzierung der Testzeit bei gleichzeitiger Entlastung des (Software-gesteuerten Haupt-) Prozessors. Dies wird erreicht durch einen automatischen Testablauf, der während des laufenden Tests keine Steuereingriffe durch den Prozessor erfordert. Typischerweise sind die Kommandos "Start des Cross Coupling Tests" und "Lesen der Testergebnisse" ausreichend. Damit wird die Komplexität der Software des Algorithmus, der im Prozessor abläuft, insgesamt reduziert.

Nach dem Start des Tests erfolgt die Aktivierung und Statuserfassung der einzelnen Schnittstellen automatisch durch die Testschaltung. Die Testergebnisse werden in Ergebnisregistern gespeichert.

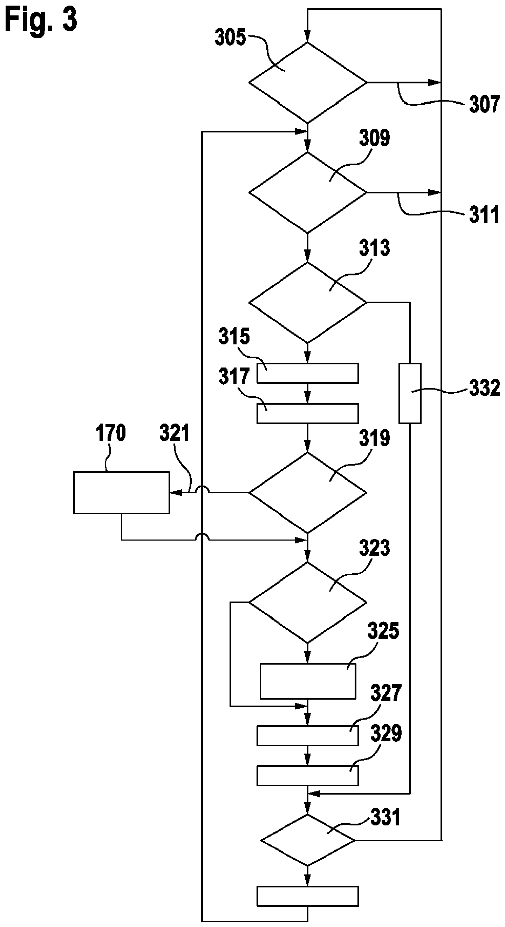

Der Testablauf ist abhängig von der Anzahl an Baueinheiten (die beispielsweise als ASICs ausgeführt sind) mit (PSI5-) Schnittstellen auf einer Platine. Bei mehreren Baueinheiten bzw. ASICs wird eine Baueinheit (ASIC) nach der anderen zum "Master(-ASIC)", das seine (PSI5-) Schnittstell(en) sequentiell für eine kurze Zeit aktiviert (d.h. ein Testsignals an der betreffenden Schnittstelle aufgibt) und die jeweils nicht aktiven Schnittstellen auf Verkopplung überwacht, wie es mit Bezug zu Fig. 3 detaillierter beschrieben wird.

Fig. 3 zeigt ein Ablaufdiagramm von Schritten, die beispielsweise in einem Master-ASIC, das heißt in einer Anschlusseinheit, die an einer Schnittstelle ein Testsignal anlegt, ausgeführt werden. In einem ersten Schritt 305 empfängt die entsprechende Anschlusseinheit ein Signal (beispielsweise von der Zentraleinheit 110 aus Fig. 1), sodass die betreffende Master-Anschlusseinheit erkennen kann, dass sie als Master- Anschlusseinheit arbeiten darf/soll. Wird ein solches Signal nicht empfangen, wird entlang dem Pfad 307 zurück zu Schritt 305 gesprungen, so dass die betreffende Anschlusseinheit wieder auf ein entsprechendes Signal der Steuereinheit 115 wartet, dass sie als Master- Anschlusseinheit arbeiten darf/soll. Wird im Schritt 305 erkannt, dass die betreffende Anschlusseinheit als Master-Anschlusseinheit arbeiten darf/soll, wird ein nachfolgender Schritt 309 ausgeführt, in dem überprüft wird, ob alle Schnittstellen zu Verbindungsleitungen ausgeschaltet (d.h. deaktiviert) sind. Folglich wird im Schritt 309 überprüft, ob alle PSI-Interfaces ausgeschaltet sind. Ist dies nicht der Fall, wird entsprechend Pfad 311 zum Schritt 305 zurückgesprungen und erneut auf ein Signal erwartet, dass die betreffende Anschlusseinheit als Master-Anschlusseinheit arbeiten soll. Wird im Schritt 309 erkannt, dass alle Schnittstellen an Verbindungsleitungen ausgeschaltet sind, wird zu einem nachfolgenden Schritt 313 gesprungen, in dem überprüft wird, ob an der n-ten Schnittstelle der Baueinheit keinen Kurzschluss zu einer Spannungsquelle (beispielsweise eine Batterie) besteht, wobei die Zählvariable n eine natürliche Zahl (beginnend bei Zahl 1) darstellt. Wird in Schritt 313 festgestellt, dass tatsächlich kein Kurzschluss an der n-ten Schnittstelle der Anschlusseinheit vorliegt, wird die Schnittstelle Nr. n im Schritt 315 eingeschaltet und nachfolgend entsprechend Schritt 317 eine vorbestimmte Zeit abgewartet, damit sich ein Spannungspegel auf einer an der Schnittstelle Nr. n angeschlossenen Verbindungsleitung einschwingen kann. Hieran anschließend wird in einem Schritt 319. überprüft, ob eine (gefilterte) Ausgabe eines die Spannung an Schnittstelle Nr. n überwachenden Schnittstellen-Spannungskomparators größer als ein vorbestimmter Schwellwert ist. Ist dies nicht der Fall, wird entsprechend Pfad 321 in einem Register 170 (entsprechend der Fig. 1) ein Fehlerwert abgespeichert, der einen Fehler "Kurzschluss nach Masse" repräsentiert. Hiernach wird zu einem Schritt 323 gesprungen, der nachfolgend noch weiter erläutert wird. Wird in Schritt 319 dagegen festgestellt, dass die Ausgabe auf Schnittstelle Nr. n größer als der Schwellwert ist, wird in einem nachfolgenden Schritt 323 überprüft, ob eine (gefilterte) Ausgabe eines, eine weitere Schnittstelle der Anschlusseinheit überwachenden, Schnittstellen-Spannungskomparators ebenfalls einen Wert liefert, der größer als ein bzw. der Schwellwert ist. Ist dies der Fall, wird in einem nachfolgenden Schritt 325 eine logische "1" (als Fehlerwert) in ein Kreuzkopplungsergebnisregister (welches beispielsweise ebenfalls im Speicher 170 angeordnet sein kann) geschrieben, wodurch ein Fehler in der Form eines Kurzschlusses ist oder einer niederohmigen Verbindung zwischen der Schnittstelle Nr. n und der weiteren Schnittstelle der betreffenden (Master-) Anschlusseinheit erkennbar wird. Hieran anschließend wird in einem Schritt 327 die Schnittstelle Nr. n der Anschlusseinheit ausgeschaltet. Wird im Schritt 323 erkannt, dass die Ausgabe eines die weitere Schnittstelle überwachenden Schnittstellen-Spannungskomparators einen Wert liefert, der nicht größer als der Schwellwert ist bzw. die Ausgabe aller die weiteren Schnittstellen der betreffenden (Master-) Anschlusseinheit überwachenden Schnittstellen-Spannungskomparatoren Werte liefern, die alle nicht größer als entsprechende Schwellenwerte sind, wird ebenfalls zum Schritt 327 gesprungen, in der die Schnittstelle Nr. n abgeschaltet wird. Nach dem Abschalten der Schnittstelle Nr. n im Schritt 327 erfolgt in Schritt 329 ein Abwarten einer vordefinierten Einschwingzeit. Auf Schritt 329 folgend wird im Schritt 331 überprüft, ob die Zählvariable einer Zahl entspricht, die die maximale Anzahl nmax von Schnittstellen in der betreffenden (Master-) Anschlusseinheit repräsentiert. Auch wird im Fall, dass im Schritt 313 ein Fehler "Kurzschluss zur Versorgungsspannung" (das heißt beispielsweise zur Batterie) erkannt wird, ein Fehlerwert abgespeichert (Schritt 332), der einen Kurzschluss zur Versorgungsspannung wie beispielsweise der Batterie darstellt und weiter zum Schritt 331 gesprungen. Wird in Schritt 331 erkannt, dass die aktuell verwendete Zählvariable n tatsächlich kleiner als die maximale Anzahl nmax von Schnittstelle in der betreffenden (Master-) Anschlusseinheit ist, wird die Zählvariable n um den Wert 1 inkrementiert und zum Schritt 309 gesprungen. Wird im Schritt 331 erkannt, dass die aktuell verwendete Zählvariable n nicht kleiner als die maximale Anzahl nmax von Schnittstellen in der betreffenden (Master-) Anschlusseinheit ist, wird zurück zum Schritt 305 gesprungen.

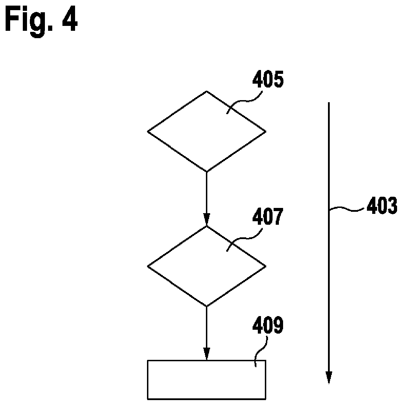

Die anderen Anschlusseinheiten (z.B. ASICs, die in diesem Fall als "Slave-ASICs" oder abhängige ASICs arbeiten) werden in einen Monitormodus geschaltet und überwachen ihre (PSI5-) Schnittstellen auf eine eventuelle Verkopplung mit dem Master-ASIC (PSI5-) Schnittstellen, wie dies mit Bezug zum Ablaufdiagramm gemäß Fig. 4 näher beschrieben wird.

Fig. 4 zeigt ein Ablaufdiagramm von Schritten, die in einer abhängig arbeitenden Baueinheit (das heißt beispielsweise einem abhängigen ASIC, also einem nicht als Master-ASIC arbeitenden ASIC oder einer nicht als Master-Anschlusseinheit arbeitender Baueinheit) ausgeführt werden. Diese Schritte werden parallel (entsprechend dem Pfeil 403 in Fig. 4) in allen in Fig. 1 dargestellten Anschlusseinheiten durchgeführt, die nicht als Master-Anschlusseinheit arbeiten. In einem ersten Schritt 405 wird überprüft, ob die betreffende Baueinheit (beispielsweise von der Steuereinheit 115 der Zentraleinheit 110) ein Signal erhalten hat, dass die betreffende Anschlusseinheit als gesteuerte Anschlusseinheit (das heißt als Slave-Anschlusseinheit) arbeiten soll. Ist dies der Fall, wird zu einem nachfolgenden Schritt 407 gesprungen, in dem überprüft wird, ob ein (gefilterter) Wert einer Ausgabe eines eine betreffende Schnittstelle der jeweiligen Anschlusseinheit überwachenden Schnittstellen-Spannungskomparators einen bestimmten Schwellwert überschreitet. Ist dies der Fall, wird in einem nachfolgenden Schritt 409 ein Fehlerwert in ein entsprechendes Kreuzkopplungsergebnisregister eingetragen, der einen Fehler des Überkoppelns des Testsignals auf die betreffende Schnittstelle der (abhängigen) Anschlusseinheit repräsentiert.

Zur Untersuchung, ob die vorliegende Erfindung in einem Produkt implementiert ist, können Steuerkommandos zur Aktivierung des Cross-Coupling-Tests und zum Lesen der Ergebnisregister ein Indiz für den Einbau der Erfindung in einem ASIC liefern. Ein eindeutiger Nachweis für einen hardwarebasierten Test ist möglich, wenn während des Testablaufs die Kommunikation zwischen Prozessor und ASICs unterbrochen wird und nach Ablauf des Tests dennoch korrekte Testergebnisse in dem Ergebnisregister gespeichert sind.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Verfahren (200) zum Feststellen zumindest eines Fehlers (125, 126, 127) in Verbindungsleitungen (120) zwischen einer Mehrzahl von elektronischen Anschlusseinheiten (117a-c) und einer Mehrzahl von voneinander unabhängigen peripheren Einheiten (130), wobei die Anschlusseinheit (117a-c) durch einen flüchtig in eine Steuereinheit (115) einprogrammierten Algorithmus gesteuert werden und wobei die Verbindungsleitungen (120) zwischen den peripheren Einheiten (130a-c) und der Anschlusseinheiten (117) je mittels zumindest einer Zweidrahtleitung ausgeführt sind, wobei das Verfahren (200) die folgenden Schritte aufweist:
- Ausgeben (210) eines Startsignals von der Steuereinheit (115) an eine erste (130a) der Anschlusseinheiten (117a), um das Feststellen des Fehlers (125) zu starten;
- Anlegen (220) eines Testsignals an eine Schnittstelle (140a) einer ersten der Anschlusseinheiten (117a), **dadurch gekennzeichnet, dass** das Anlegen des Testsignals durch einen nicht-flüchtig in der ersten Anschlusseinheit (117a) einprogrammierten ersten Algorithmus (160a) überwacht und/oder gesteuert wird;
- Erfassen (230) eines Überkoppelns des Testsignals an eine Schnittstelle (140b) einer zweiten Anschlusseinheit (117b) und Ablegen eines das Überkoppeln repräsentierenden Fehlerwertes in einem ersten Register (170b), wobei das Erfassen und Ablegen des Fehlerwertes durch einen nicht-flüchtig in der zweiten Anschlusseinheit (117b) einprogrammierten zweiten Algorithmus (160b) gesteuert wird; und
- Auslesen (240) des zumindest einen Fehlerwertes durch die Steuereinheit (110) zumindest aus dem ersten Register (170b), um den Fehler in den Verbindungsleitungen (120) zwischen der ersten Anschlusseinheit (117a) und der Mehrzahl von peripheren Einheiten (130) festzustellen.

2. Verfahren (200) gemäß Anspruch 1, **dadurch gekennzeichnet, dass** im Schritt des Erfassens (230) ferner ein Erfassen eines Überkoppelns des Testsignals auf eine zweite Schnittstelle (150a) der ersten Anschlusseinheit (117a) und ein Ablegen eines das Überkoppeln repräsentierenden zweiten Fehlerwertes in ein zweites Register (170a) erfolgt, wobei das Erfassen eines Überkoppelns des Testsignals auf die zweite Schnittstelle (150a) der ersten Anschlusseinheit (117a) und das Ablegen des zweiten Fehlerwertes durch den ersten Algorithmus (160a) überwacht wird.

3. Verfahren (200) gemäß einem der vorangegangenen Ansprüche, **gekennzeichnet, durch** einen Schritt des Anlegens eines weiteren Testsignals an der Schnittstelle (140b) der zweiten Anschlusseinheit (117b), wobei das Anlegens des weiteren Testsignals durch den zweiten Algorithmus (160b) überwacht wird und wobei ferner Schritte des Erfassens eines Überkoppelns des weiteren Testsignals an die erste Schnittstelle (140a) in der ersten Anschlusseinheit (117a) und des Ablegens eines das Überkoppeln des weiteren Testsignals repräsentierenden dritten Fehlerwertes in einem dritten Register (170a) vorgesehen ist, wobei die Schritte des Erfassens des Überkoppelns des weiteren Testsignals und des Ablegens des dritten Fehlerwertes durch den ersten Algorithmus (160a) überwacht und/oder gesteuert werden.

4. Verfahren (200) gemäß Anspruch 3, **dadurch gekennzeichnet, dass** im Schritt des Erfassens eines Überkoppelns des weiteren Testsignals ferner ein Erfassen eines Überkoppelns des weiteren Testsignals auf zumindest eine zweite Schnittstelle (150b) der zweiten Anschlusseinheit (117b) und ein Ablegen eines das Überkoppeln repräsentierenden vierten Fehlerwertes in einem vierten Register (170b) erfolgt, wobei das Erfassen des Überkoppelns des weiteren Testsignals und das Ablegen des vierten Fehlerwertes durch den zweiten Algorithmus (160b) überwacht und/oder gesteuert wird.

5. Verfahren (200) gemäß einem der Ansprüche 3 oder 4, **dadurch gekennzeichnet, dass** vor dem Schritt des Anlegens des weiteren Testsignals ein Steuersignal vom ersten Algorithmus (160a) an den zweiten Algorithmus (160b) ausgegeben wird, um das Anlegen des weiteren Testsignals durch den zweiten Algorithmus (160b) zu starten.

6. Verfahren (200) gemäß einem der vorangegangenen Ansprüche, **dadurch gekennzeichnet, dass** im Schritt des Erfassens (230) ferner ein Erfassen eines Überkoppelns des Testsignals auf eine Schnittstelle (140c) einer dritten Anschlusseinheit (117c) und ein Ablegen eines das Überkoppeln des Testsignals auf die Schnittstelle (140c) der dritten Anschlusseinheit (117c) repräsentierenden fünften Fehlerwertes in einem fünften Register (170c) erfolgt, wobei das Erfassen des Überkoppelns des Testsignals auf die Schnittstelle (140c) der dritten Anschlusseinheit (117c) und das Ablegen des fünften Fehlerwertes durch einen nicht-flüchtig in der dritten Anschlusseinheit (117c) einprogrammierten dritten Algorithmus (160c) überwacht und/oder gesteuert wird.

7. Verfahren (200) gemäß einem der vorangegangenen Ansprüche, **dadurch gekennzeichnet, dass** zwischen dem Schritt des Anlegens (220) und dem Schritt des Erfassens (230) eine vordefinierte Zeitdauer abgewartet wird.

8. Verfahren (200) gemäß einem der vorangegangenen Ansprüche, **dadurch gekennzeichnet, dass** im Schritt des Erfassens (230) ein Ablegen des Fehlerwertes in dem ersten Register (170b) erfolgt, wobei das erste Register ein Teil der zweiten Anschlusseinheit (117b) ist oder wobei das erste Register (170b) ein Teil der Steuereinheit (115) ist.

9. Verfahren (200) gemäß einem der vorangegangenen Ansprüche, **dadurch gekennzeichnet, dass** das Verfahren (200) unter Verwendung von PSI5-Schnittstellen (140a-b, 150a-b) zumindest als Schnittstelle in der ersten Anschlusseinheit (117a) und als Schnittstelle in der zweiten Anschlusseinheit (117b) ausgeführt wird.

## Claims

1. Method (200) for detecting at least one fault (125, 126, 127) in connecting lines (120) between a plurality of electronic connecting units (117a-c) and a plurality of mutually independent peripheral units (130), wherein the connecting units (117a-c) are controlled by an algorithm programmed in volatile fashion into a control unit (115) and wherein the connecting lines (120) between the peripheral units (130a-c) and the connecting units (117) are each embodied by means of at least one two-wire line, wherein the method (200) has the following steps:
- outputting (210) a start signal from the control unit (115) to a first (130a) of the connecting units (117a) in order to start detecting the fault (125);
- applying (220) a test signal to an interface (140a) of a first of the connecting units (117a), **characterized in that** the applying of the test signal is monitored and/or controlled by a first algorithm (160a) programmed in non-volatile fashion into the first connecting unit (117a);
- detecting (230) a cross-coupling of the test signal onto an interface (140b) of a second connecting unit (117b) and storing an error value representing the cross-coupling in a first register (170b), wherein the detecting and storing of the error value is controlled by a second algorithm (160b) programmed in non-volatile fashion into the second connecting unit (117b); and
- reading (240) the at least one error value from at least the first register (170b) by means of the control unit (110) in order to detect the fault in the connecting lines (120) between the first connecting unit (117a) and the plurality of peripheral units (130) .

2. Method (200) according to Claim 1, **characterized in that** the detecting step (230) furthermore involves a cross-coupling of the test signal onto a second interface (150a) of the first connecting unit (117a) being detected and a second error value representing the cross-coupling being stored in a second register (170a), wherein the detecting of a cross-coupling of the test signal onto the second interface (150a) of the first connecting unit (117a) and the storing of the second error value are monitored by the first algorithm (160a) .

3. Method (200) according to either of the preceding claims, **characterized by** a step of applying a further test signal to the interface (140b) of the second connecting unit (117b), wherein the applying of the further test signal is monitored by the second algorithm (160b) and wherein, furthermore, there is provision for steps of detecting a cross-coupling of the further test signal onto the first interface (140a) in the first connecting unit (117a) and storing a third error value representing the cross-coupling of the further test signal in a third register (170a), wherein the steps of detecting the cross-coupling of the further test signal and storing the third error value are monitored and/or controlled by the first algorithm (160a) .

4. Method (200) according to Claim 3, **characterized in that** the step of detecting a cross-coupling of the further test signal furthermore involves a cross-coupling of the further test signal onto at least one second interface (150b) of the second connecting unit (117b) being detected and a fourth error value representing the cross-coupling being stored in a fourth register (170b), wherein the detecting of the cross-coupling of the further test signal and the storing of the fourth error value are monitored and/or controlled by the second algorithm (160b).

5. Method (200) according to either of Claims 3 and 4, **characterized in that** the step of applying the further test signal is preceded by a control signal being output from the first algorithm (160a) to the second algorithm (160b) in order to start applying the further test signal by means of the second algorithm (160b) .

6. Method (200) according to one of the preceding claims, **characterized in that** the detecting step (230) furthermore involves a cross-coupling of the test signal onto an interface (140c) of a third connecting unit (117c) being detected and a fifth error value representing the cross-coupling of the test signal onto the interface (140c) of the third connecting unit (117c) being stored in a fifth register (170c), wherein the detecting of the cross-coupling of the test signal onto the interface (140c) of the third connecting unit (117c) and the storing of the fifth error value are monitored and/or controlled by a third algorithm (160c) programmed in non-volatile fashion into the third connecting unit (117c).

7. Method (200) according to one of the preceding claims, **characterized in that** a predefined period is waited between the applying step (220) and the detecting step (230).

8. Method (200) according to one of the preceding claims, **characterized in that** the detecting step (230) involves the error value being stored in the first register (170b), wherein the first register is part of the second connecting unit (117b) or wherein the first register (170b) is part of the control unit (115).

9. Method (200) according to one of the preceding claims, **characterized in that** the method (200) is carried out using PSI5 interfaces (140a-b, 150a-b) at least as interface in the first connecting unit (117a) and as interface in the second connecting unit (117b).

## Revendications

1. Procédé (200) de détermination d'au moins un défaut (125, 126, 127) dans des lignes de liaison (120) entre une pluralité d'unités de connexion électroniques (117a-c) et une pluralité d'unités périphériques (130) indépendantes les unes des autres, l'unité de connexion (117a-c) étant commandée par un algorithme programmé de manière volatile dans une unité de commande (115), et les lignes de liaison (120) étant chacune réalisées entre les unités périphériques (130a-c) et les unités de connexion (117) au moyen d'au moins une ligne bifilaire, le procédé (200) comprenant les étapes suivantes :
- délivrer en sortie (210) un signal de démarrage de l'unité de commande (115) à une première (130a) des unités de connexion (117a) afin de démarrer la détermination de l'erreur (125) ;
- appliquer (220) un signal de test à une interface (140a) d'une première des unités de connexion (117a), **caractérisé en ce que** l'application du signal de test est surveillée et/ou commandée par un premier algorithme non volatil (160a) programmé dans la première unité de connexion (117a) ;
- détecter (230) un surcouplage du signal de test à une interface (140b) d'une deuxième unité de connexion (117b) et stocker une valeur d'erreur, représentative du surcouplage, dans un premier registre (170b), la détection et le stockage de la valeur d'erreur étant commandés par un deuxième algorithme non volatil (160b) programmé dans la deuxième unité de connexion (117b) ; et
- lire (240) l'au moins une valeur d'erreur à l'aide de l'unité de commande (110) au moins dans le premier registre (170b) pour déterminer l'erreur dans les lignes de liaison (120) entre la première unité de connexion (117a) et la pluralité d'unités périphériques (130) .

2. Procédé (200) selon la revendication 1, **caractérisé en ce que,** à l'étape de détection (230), une détection d'un surcouplage du signal de test à une deuxième interface (150a) de la première unité de connexion (117a) et un stockage d'une deuxième valeur d'erreur, représentative du surcouplage, sont effectués dans un deuxième registre (170a), la détection d'un surcouplage du signal de test à la deuxième interface (150a) de la première unité de connexion (117a) et le stockage de la deuxième valeur d'erreur étant surveillés par le premier algorithme (160a).

3. Procédé (200) selon l'une des revendications précédentes, **caractérisé par** une étape d'application d'un autre signal de test à l'interface (140b) de la deuxième unité de connexion (117b), l'application de l'autre signal de test étant surveillée par le deuxième algorithme (160b) et des étapes de détection d'un surcouplage de l'autre signal de test à la première interface (140a) dans la première unité de connexion (117a) et de stockage d'une troisième valeur d'erreur représentative du surcouplage de l'autre signal de test dans un troisième registre (170a) étant en outre prévues, les étapes de détection du surcouplage de l'autre signal de test et de stockage de la troisième valeur d'erreur étant surveillées et/ou commandées par le premier algorithme (160a).

4. Procédé (200) selon la revendication 3, **caractérisé en ce que,** dans l'étape de détection de surcouplage de l'autre signal de test, une détection de surcouplage de l'autre signal de test à au moins une deuxième interface (150b) de la deuxième unité de connexion (117b) et un stockage d'une quatrième valeur d'erreur représentative du surcouplage étant dans un quatrième registre (170b) en outre effectués, la détection du surcouplage de l'autre signal de test et le stockage de la quatrième valeur d'erreur étant surveillés et/ou commandés par le deuxième algorithme (160b) .

5. Procédé (200) selon l'une des revendications 3 et 4, **caractérisé en ce que,** avant l'étape d'application de l'autre signal de test, un signal de commande est délivré en sortie du premier algorithme (160a) au deuxième algorithme (160b) pour démarrer l'application de l'autre signal de test par le deuxième algorithme (160b) .

6. Procédé (200) selon l'une des revendications précédentes, **caractérisé en ce que,** à l'étape de détection (230), une détection d'un surcouplage du signal de test à une interface (140c) d'une troisième unité de connexion (117c) et un stockage d'une cinquième valeur d'erreur, représentative du surcouplage du signal de test à l'interface (140c) de la troisième unité de connexion (117c), dans un cinquième registre (170c) étant effectués, la détection du surcouplage du signal de test à l'interface (140c) de la troisième unité de connexion (117c) et le stockage de la cinquième valeur d'erreur étant surveillés et/ou commandés par un troisième algorithme (160c) programmé de manière non volatile dans la troisième unité de connexion (117c).

7. Procédé (200) selon l'une des revendications précédentes, **caractérisé en ce qu'**une durée prédéfinie est attendue entre l'étape d'application (220) et l'étape de détection (230).

8. Procédé (200) selon l'une des revendications précédentes, **caractérisé en ce que,** à l'étape de détection (230), un stockage de la valeur d'erreur dans le premier registre (170b) est effectué, le premier registre faisant partie de la deuxième unité de connexion (117b) ou le premier registre (170b) faisant partie de l'unité de commande (115).

9. Procédé (200) selon l'une des revendications précédentes, **caractérisé en ce que** le procédé (200) est mis en œuvre à l'aide d'interfaces PSI5 (140a-b, 150a-b) au moins comme interface dans la première unité de connexion (117a) et comme interface dans la deuxième unité de connexion (117b).
